# EUROPÄISCHE PATENTANMELDUNG

(11) **EP 1 284 303 A1**
(43) Veröffentlichungstag der Anmeldung: **19.02.2003**
(21) Anmeldenummer: 02018330.7
(22) Anmeldetag: 14.08.2002
(51) Int. Cl.: C23C 14/34

(54) **Sputtertarget aus einer Siliziumlegierung und Verfahren zur Herstellung eines Sputtertargets**

(30) Priorität: 18.08.2001 DE 10140589
(71) Anmelder: W.C. Heraeus GmbH & Co. KG, 63450 Hanau (DE)
(72) Erfinder: Heindel, Josef, 63512 Hainburg (DE); Simons, Christoph, Dr., 63599 Biebergemünd (DE); Weigert, Martin, Dr., 63457 Hanau (DE)
(74) Vertreter: Kühn, Hans-Christian

(57) **Zusammenfassung**

Bei der Herstellung von Sputtertargets verwendet man in der Regel ein Pulvergemisch aus Silizium und Aluminium. Verwendet man zum Auftrag des Pulvergemischs z.B. ein Plasmaspritzverfahren, so schwankt die Verteilung von Aluminium im Sputtertarget stark. Gemäß der Erfindung soll daher ein Legierungspulver genutzt werden, wobei die einzelnen Körner aus einer Si/Al-Legierung bestehen. Es zeigt sich, dass damit eine hohe Homogenität des Sputtertargets erreicht werden kann.

## Beschreibung

Die Erfindung bezieht sich auf ein Sputtertarget, das im wesentlichen aus Silizium und Aluminium besteht und ein Verfahren zur Herstellung eines solchen Sputtertargets.

Sputtertargets aus einer Si-AI-Legierung werden in der Dünnschichttechnik häufig zum reaktiven Sputtern optischer Funktionsschichten aus Si₃N₄ oder SiO₂ eingesetzt. Im Prinzip ist man an den optischen Eigenschaften des SiO₂ bzw. Si₃N₄ interessiert: Das Aluminium wird in aller Regel nur beigefügt, um eine ausreichende elektrische Leitfähigkeit des Sputtertargets zu erzeugen beziehungsweise um dessen Sprödigkeit und Rissempfindlichkeit herabzusetzen. Für die gewünschte Funktion der späteren Dünnschicht ist das Aluminium im Target nutzlos, gelegentlich sogar störend.

Zur Herstellung von Sputtertargets aus Si-AI sind verschiedene Methoden bekannt: Schmelzverfahren mit langsamer Blockerstarrung, Gießen dünner Kacheln ( wie in der DE 198 10 246 Al beschrieben ) oder pulvermetallurgische Verfahren, wie z. B. Heißpress- bzw. heißisostatische Pressverfahren oder thermisches Spritzen.

Insbesondere bei der Herstellung von zylinderförmigen Rohrkathoden haben sich thermische Spritzverfahren wie Flammspritzen oder Plasmaspritzen bewährt. Dabei wird ein Gemisch aus einem handelsüblichen elementaren Silizium- und einem Aluminiumpulver eingesetzt. Ein solches Verfahren ist in der EP 0 586 809 B1 beschrieben. Demnach sollen die einzelnen Siliziumpartikel zumindest zum Teil mit einer Schicht aus Aluminium überzogen werden.

Allerdings ist folgendes zu beachten: Handelsübliche Silizium- und Aluminiumpulver unterscheiden sich in der Regel in ihrer Kornform. Während beim Siliziumpulver die Körner häufig die kantige Struktur eines Mahlprozesses aufweisen, haben die Körner eines Aluminiumpulvers immer eine kugelige bis kugelig spratzige Geometrie. Bei allen pulvermetallurgischen Verfahren, bei denen zwei derartig unterschiedliche Arten von Pulver gemischt werden müssen, ist die Gefahr der Pulverentmischung bei der Herstellung des Produktes hoch. Insbesondere wenn das Sputtertarget durch ein thermisches Pulverspritzverfahren hergestellt wird, bei dem das zu spritzende Pulver über einen Fördermechanismus der Spritzpistole zugeführt wird, können im Ergebnis deutliche Abweichungen in der Targetzusammensetzung auftreten. Weiterhin besteht die große Gefahr, dass bei großen Unterschieden in Schmelzpunkt und Dampfdruck, wie dies bei Silizium und Aluminium der Fall ist, es zu An- oder Abreicherungen einer Komponente in der Spritzschicht kommt.

Messungen haben gezeigt, dass Schwankungen bis zu relativ 80% im Al-Gehalt eines Plasma gespritzten 3700 mm langen Si-AI-Targets für eine Rohrkathode auftreten. Aber auch bei Verwendung anderer pulvermetallurgischer Fertigungsverfahren wie Heißpressen oder heißisostatisches Pressen besteht bei Verwendung mehrkomponentiger Pulver mit unterschiedlicher Größe und Morphologie die Gefahr einer Entmischung während der Verarbeitung.

In einem Sputtertarget sind derartige Schwankungen im Aluminiumgehalt natürlich unerwünscht, da sie zu ernsthaften Abweichungen der optischen Parameter auf der späteren Dünnschicht führen können.

Die Aufgabe der vorliegenden Erfindung besteht somit darin, ein SiAI-Sputtertarget darzustellen, das möglichst keine oder nur geringe Schwankungen im Al-Gehalt aufweist, und ein Herstellungsverfahren für solche Sputtertargets zu entwickeln.

Diese Aufgabe wird erfindungsgemäß durch ein Sputtertarget, das einen größeren Anteil Silizium und einen kleineren Anteil Aluminium enthält, gelöst, indem das Sputtertarget durch ein Formgebungs- und / oder Verdichtungsverfahren aus einer pulverförmigen Silizium-Aluminium-Legierung gebildet ist.

Silizium ist ein häufig eingesetztes Beschichtungsmaterial, das die optischen Eigenschaften des beschichteten Trägers beeinflussen soll. Aluminium ist ein ebenso häufig eingesetztes Material, um die Sprödigkeit des im Wesentlichen aus Silizium bestehenden Sputtertargets herabzusetzen. In einigen Sonderfällen werden auch andere Materialien eingesetzt, bei denen das erfindungsgemäße Verfahren in entsprechender Weise eingesetzt werden kann.

Das Sputtertarget ist somit dadurch ausgezeichnet, dass zu seiner Herstellung anstelle zweier verschiedener Sorten Pulver, nämlich typischerweise einem Si- und einem Al-Pulver, ein einziges einheitliches, allerdings zweiphasiges SiAI-Legierungspulver verwendet wird. Das zu verwendende SiAl-Legierungspulver besitzt vorzugsweise einen Al-Gehalt im Bereich von 0,1 bis 30 Gew.-%, insbesondere von 5 bis 15 Gew.-%. Aber auch andere Al-Gehalte sind einstellbar und verwendbar.

Das Sputtertarget ist insbesondere dadurch gekennzeichnet, dass zu seiner Herstellung zunächst eine Schmelze aus Silizium und Aluminium erzeugt wird, dass aus der Schmelze ein Pulver hergestellt wird, dessen zweiphasige Körner aus der Aluminium-Siliziumlegierung bestehen, und dass das Pulver mit einem pulvermetallurgischen Fertigungsverfahren auf einen Träger aufgebracht wird.

Ein herausragendes Charakteristikum dieses Legierungspulvers ist die feine Ausscheidungsverteilung des Al im Si-Korn. Überraschenderweise bleibt diese äußerst homogene Verteilung der Al-Phase sogar erhalten, wenn man als Formgebungsverfahren das thermische Spritzen einsetzt.

Da die Al-Phase als Al-Ausscheidungen im Si-Korn vorliegt, wird sie während des thermischen Spritzprozesses durch das sie ummantelnde Si-Korn geschützt und kann nicht verdampfen. Dieser Umstand führt vermutlich dazu, dass der Al-Gehalt des Legierungspulvers auch in der Spritzschicht beziehungsweise im Targetmaterial mit minimalen Abweichungen erhalten bleibt. Dies geschieht im Gegensatz zu der Lehre der EP 0 586 809, wonach das Aluminium das Siliziumkorn ummanteln soll.

Als besonders vorteilhaft erweist es sich, wenn das verwendete Legierungspulver eine möglichst sphäroidische Form hat. Speziell bei Verwendung eines thermischen Spritzverfahrens als Formgebungsverfahren erhält man dadurch besonders gute Dichten und besonders hohe Auftragsraten und somit einen sehr wirtschaftlichen Herstellprozess.

Da für das Sputtertarget zunächst ein Spezialpulver - nämlich das Legierungspulver - hergestellt werden muss und nicht auf im Großhandel erhältliche Pulver zurückgegriffen werden kann, ergibt sich ein kleiner Kostennachteil gegenüber den Sputtertargets nach dem Stand der Technik. Wenn man allerdings ein Gasverdüsungsverfahren mit luftoffener Schmelze zur Herstellung des Pulvers verwendet, wird der Kostennachteil des Legierungspulvers fast kompensiert. Überraschenderweise zeigt sich, dass der Sauerstoffgehalt nach einer Gasverdüsung mit luftoffener Schmelze den niedrigen Gasgehalten der üblichen Pulvermischungen nahe kommt und somit Nachteile aus der luftoffenen Schmelze im späteren Sputterprozess nicht erwarten lässt.

Die Aufgabe wird durch ein weiteres Sputtertarget dadurch gelöst, dass das Sputtertarget aus kugelformähnlichen Siliziumkörnern gebildet ist, die eine Siliziummatrix bilden, und wobei das Aluminium fein und / oder feinst verteilt in den Siliziumkörnern vorliegt.
Während bei einem Sputtertarget, das nach einem Verfahren gemäß dem Stand der Technik hergestellt ist, Körner aus Silizium und Aluminium nebeneinander vorliegen, wobei die Verteilung des Aluminiums im Silizium deutlich variieren kann, ergibt sich für ein Sputtertarget gemäß der Erfindung ein Einschluss von Aluminium in einer aus Si-Körnern gebildeten Siliziummatrix, was sicherstellt, dass das Aluminium im Sputtertarget gleichmäßig verteilt ist.

Vorzugsweise liegt der Aluminiumgehalt des Sputtertargets im Bereich von 0.1 bis 30 Gew.-%, insbesondere von 5 bis 15 Gew.-%. Aber auch andere Al-Gehalte sind einstellbar und verwendbar.

Als besonders vorteilhaft hat es sich erwiesen, wenn das Aluminium in den Siliziumkörnern in Form von fein und / oder feinst verteilten Aluminiumspots eingeschlossen ist. Dadurch wird sichergestellt, dass das Aluminium tatsächlich gleichmäßig im Sputtertargetmaterial verteilt ist.

Die Erfindung bezieht sich weiterhin auf ein Verfahren zur Herstellung der eben beschriebenen Sputtertargets. Ein solches Verfahren soll preisgünstig sein und ein Sputtertarget erzeugen, das eine möglichst gleichbleibende Zusammensetzung aufweist, insbesondere soll der Gehalt an Aluminium keinen räumlichen Schwankungen unterliegen.

Die Aufgabe wird für das Verfahren zur Herstellung eines solchen Sputtertargets, das im wesentlichen aus Silizium und Aluminium besteht und das einen größeren Anteil Silizium und einen kleineren Anteil Aluminium enthält, dadurch gelöst, dass das Sputtertarget durch ein Formgebungs- und / oder Verdichtungsverfahren aus einer pulverförmigen Silizium - Aluminium - Legierung gebildet wird.

Um die benötigte Silizium-Aluminiumlegierung in Pulverform zur Verfügung zu stellen, wird vorzugsweise zunächst eine Schmelze aus Silizium und Aluminium erzeugt und aus dieser ein Pulver hergestellt, dessen zweiphasige Körner aus einer Legierung der beiden Materialien bestehen. Danach wird das Pulver mit einem pulvermetallurgischen Fertigungsverfahren auf einen Träger zur Bildung des Sputtertargets aufgebracht.

Dabei hat es sich bewährt, eine Schmelze mit einem Aluminiumgehalt im Bereich von 0.1 bis 30 Gew.-%, insbesondere von 5 bis 15 Gew.-%, und Rest Silizium herzustellen.

Vorzugsweise wird das aus den zweiphasigen Körnern bestehende Legierungspulver mittels eines thermischen Spritzverfahrens auf den Träger aufgebracht.

Dieses Verfahren arbeitet dann besonders gut, wenn die Körner des verwendeten Pulvers eine sphäroidische Form aufweisen.

Ein bevorzugtes Verfahren zur Herstellung des Pulvers ist ein Gasverdüsungsverfahren mit einer luftoffenen Schmelze.

Im Folgenden soll die Erfindung beispielhaft erläutert werden. Der Unterschied zum Stand der Technik soll durch zwei Figuren verdeutlicht werden, die ein Sputtertarget nach dem Stand der Technik und eines gemäß der Erfindung zeigen.
Fig. 1 zeigt das Gefüge eines mit dem erfindungsgemäßen Legierungspulver Plasma gespritzten Target, während
Fig. 2 das Gefüge eines herkömmlich hergestellten Targets zeigt.

Nachfolgend wird die Herstellung des erfindungsgemäßen Targets beispielhaft erläutert. Zunächst wird ein Legierungspulver erzeugt:

### - Legierungspulver -

Zur Herstellung des Legierungspulvers wird eine luftoffene Schmelze aus 90 Gew.-% Si und 10 Gew.-% Al, kurz SiAl10 genannt, unter Inertgas verdüst. Anschließend wird das verdüste SiAl10-Pulver zum Zwecke des Plasmaspritzens auf eine Kornfraktion von 45 - 150 µm gesiebt. Das resultierende Pulver weist vorwiegend Körner mit einer sphäroidischen Form auf.

Der Sauerstoffgehalt des Pulvers sowie eines Vergleichspulvers gehen aus der folgenden Tabelle 1 hervor:

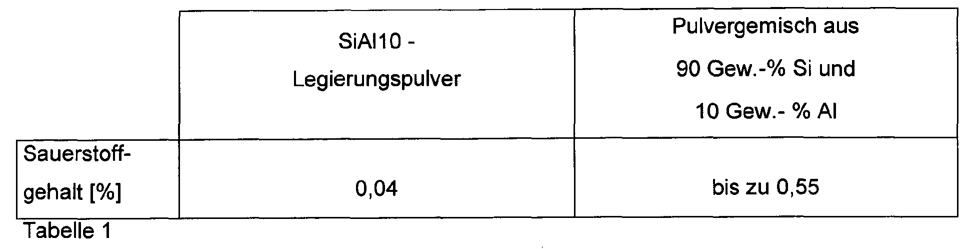

Nach der Herstellung des Legierungspulvers wird es zu einem Sputtertarget geformt:

### - Formgebung -

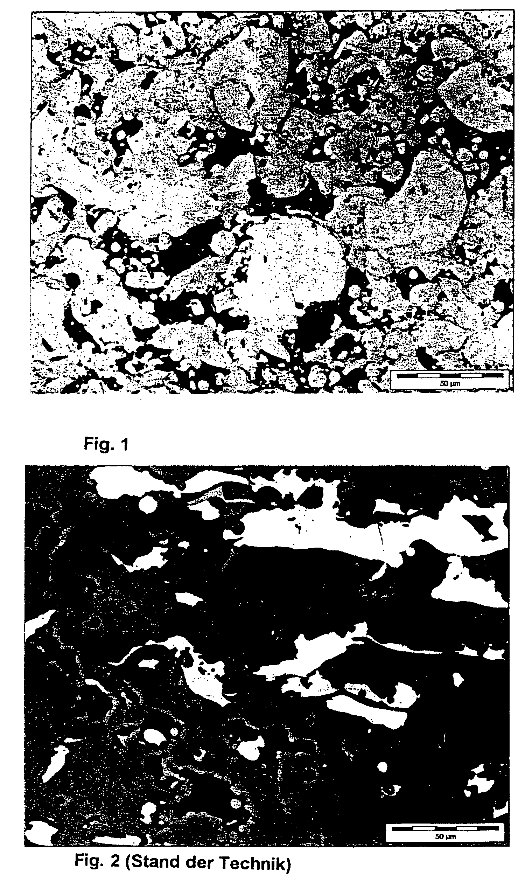

Wird das SiAl10-Legierungspulver unter einem Argon-Strom in normaler Umgebungsatmosphäre Plasma gespritzt ( APS atmospheric plasma spraying ), so werden Gefüge nach Figur 1 erzielt. Figur 2 zeigt zum Vergleich die Ergebnisse nach dem Stand der Technik, also das Gefüge eines aus einem Si- / Al-Pulvergemisch Plasma gespritzten Targets.

Man erkennt deutlich, dass das Target, das gemäß der Erfindung hergestellt ist, eine größere Homogenität aufweist.

Das SiAl10-Pulver kann auch unter "Vakuum", d.h. low pressure plasma spraying LPPS, Plasma gespritzt werden. Hierbei kann der resultierende Sauerstoffgehalt des Targetmaterials weiter abgesenkt werden, da die Spritzatmosphäre frei von umgebendem Sauerstoff gehalten wird.

Ebenso eignet sich das Verfahren des heißisostatischen Pressens HIP zur Formgebung des Pulvers. Hierbei wird das Legierungspulver in eine HIP-Kanne gefüllt und bei Temperaturen zwischen 600°C und 1100°C sowie einem Druck von 2000 bar verdichtet.

Die folgende Tabelle 2 gibt Materialdaten von SiAl10-Targets wieder, die einerseits mit einem Si/Al-Mischpulver und andererseits mit einem erfindungsgemäßen SiAl10-Legierungspulver hergestellt sind.

**Tabelle 2**

| Target hergestellt mittels Pulvermischung aus 90 Gew.-% Si- und 10 Gew.-% Al-Pulver | | | | Target hergestellt mittels SiAl10 - Legierungspulver | | |
|---|---|---|---|---|---|---|
| LLPS | APS | HIP | | LLPS | APS | HIP |
| 0,07 | 0,57 | 0,56 | Sauerstoffgehalt [%] | 0,09 | 0,46 | 0,08 |
| 2,20 | 2,18 | 2,31 | Dichte [g/cm3] | 2,18 | 2,16 | 2,32 |
| 5 - 30 | 0,5 - 40 | 70 - 200 | Si-Korngröße [µm] | 1 - 50 | 1 - 50 | 45 - 150 |
| 10 - 100 | 15 - 100 | 50 - 150 | Ausscheidungsgröße [µm] | 1 - 10 | 1 - 10 | 1 - 10 |
| 9 - 18 | 9 - 18 | 10 - 12 | Al-Gehalt [%] | 10,0 | 9,8 | 9,9 |

Die Tabelle 2 zeigt deutlich, dass sich insbesondere beim Al-Gehalt unabhängig vom Auftragungsverfahren stets ein konstanter Wert einstellt.

Das Ergebnis ist in Fig. 1 zu sehen. Das Legierungspulver bildet im Sputtertarget eine aus im Durchmesser ca. 50 µm großen Einzelkugeln bestehende Struktur, wobei sich an diese kleinere Satellitenkugeln anlegen. Jede Kugel besteht im Wesentlichen aus Silizium, das in der Figur hellgrau wiedergegeben ist. In diesen Kugeln sind feine und feinste Aluminiumspots gleichmäßig verteilt, die als kleine weiße Flecken mit einem Durchmesser von maximal 5 µm zu erkennen sind. Da jede Siliziumkugel solche Spots einschließt, ist das Aluminium gleichmäßig über das Sputtertarget verteilt. Bei den dunklen Flächen handelt es sich um Poren im Sputtertarget. Sie nehmen ein Volumen von ca. 10 % des Sputtertargets ein.

Die deutlich andere Struktur des erfindungsgemäßen Targets ergibt sich auch aus dem Vergleich mit der Probe nach Fig. 2, die ein nach herkömmlichen Methoden hergestelltes Sputtertarget zeigt. Da dabei ein Pulvergemisch auf den Träger für das Sputtertarget gebracht wird, kommt es zu großflächigen Zusammenlagerungen von Aluminium bzw. Silizium. Das Silizium ist als hellgraue Fläche, das Aluminium als weiße Fläche zu erkennen. Insbesondere am oberen Rand des Bildes erkennt man eine langgestreckte weiße Fläche, die ca. 120 µm breit und 20 - 30 µm hoch ist. Bei den dunklen Flächen handelt es sich um Poren. Die grobe Zusammenballung des Aluminiums verhindert, dass die Sprödigkeit des Sputtertargets deutlich herabgesetzt wird.

Ein nach dem erfindungsgemäßen Verfahren - unter Verwendung eines mittels Gasverdüsung einer SiAl-Schmelze hergestellten Pulvers ― hergestelltes Sputtertarget lässt sich somit gut daran erkennen, dass in einer angenäherten Kugelform vorliegendes Silizium fein und feinst verteiltes Aluminium einschließt, wobei die Aluminiumspots deutlich kleiner sind als die Siliziumkugeln.

## Patentansprüche

1. Sputtertarget, das im wesentlichen aus Silizium und Aluminium besteht und einen größeren Anteil Silizium und einen kleineren Anteil Aluminium enthält, **dadurch gekennzeichnet, dass** das Sputtertarget durch ein Formgebungs- und / oder Verdichtungsverfahren aus einer pulverförmigen Silizium - Aluminium - Legierung gebildet ist.

2. Sputtertarget nach Anspruch 1, **dadurch gekennzeichnet, dass** zunächst eine Schmelze aus Silizium und Aluminium erzeugt wird, dass aus der Schmelze ein Pulver hergestellt wird, dessen zweiphasige Körner aus einer Legierung der beiden Materialien bestehen, und dass das Pulver mit einem pulvermetallurgischen Fertigungsverfahren auf einen Träger zur Bildung des Sputtertargets aufgebracht ist.

3. Sputtertarget nach Anspruch 2, **dadurch gekennzeichnet, dass** das aus den zweiphasigen Körnern bestehende Legierungspulver mittels eines thermischen Spritzverfahrens auf den Träger aufgebracht ist.

4. Sputtertarget nach einem der vorhergehenden Ansprüche, **dadurch gekennzeichnet, dass** die Körner des verwendeten Pulvers eine sphäroidische Form aufweisen.

5. Sputtertarget nach einem der vorhergehenden Ansprüche, **dadurch gekennzeichnet, dass** zur Herstellung des Pulvers ein Gasverdüsungsverfahren mit einer luftoffenen Schmelze zum Einsatz kommt.

6. Sputtertarget nach einem der Ansprüche 1 bis 5, **dadurch gekennzeichnet, dass** das Silizium - Aluminium - Legierungspulver beziehungsweise das daraus gebildete Sputtertarget einen Aluminiumgehalt im Bereich von 0.1 bis 30 Gew.-% aufweist.

7. Sputtertarget nach Anspruch 6, **dadurch gekennzeichnet, dass** das Silizium - Aluminium ― Legierungspulver einen Aluminiumgehalt im Bereich von 5 bis 15 Gew.-% aufweist.

8. Sputtertarget, das im wesentlichen aus Silizium und Aluminium besteht, wobei das Sputtertarget aus kugelformähnlichen Silizumkörnern gebildet ist, die eine Siliziummatrix bilden, und wobei das Aluminium fein und / oder feinst verteilt in den Siliziumkörnern vorliegt.

9. Sputtertarget nach Anspruch 8, **dadurch gekennzeichnet, dass** das Silizium - Aluminium-Legierungspulver beziehungsweise das daraus gebildete Sputtertarget einen Aluminiumgehalt im Bereich von 0.1 bis 30 Gew.-% aufweist.

10. Sputtertarget nach Anspruch 9, **dadurch gekennzeichnet, dass** das Silizium - Aluminium ― Legierungspulver einen Aluminiumgehalt im Bereich von 5 bis 15 Gew.-% aufweist.

11. Sputtertarget nach einem der Ansprüche 8 bis 10, **dadurch gekennzeichnet, dass** das Aluminium in den Siliziumkörnern in Form von fein und / oder feinst verteilten Aluminiumspots eingeschlossen ist.

12. Verfahren zur Herstellung eines Sputtertargets, das im wesentlichen aus Silizium und Aluminium besteht und das einen größeren Anteil Silizium und einen kleineren Anteil Aluminium enthält, **dadurch gekennzeichnet, dass** das Sputtertarget durch ein Formgebungs- und /oder Verdichtungsverfahren aus einer pulverförmigen Silizium ― Aluminium - Legierung gebildet wird.

13. Verfahren nach Anspruch 12, **dadurch gekennzeichnet, dass** zunächst eine Schmelze aus Silizium und Aluminium erzeugt wird, dass aus der Schmelze ein Pulver hergestellt wird, dessen zweiphasige Körner aus einer Legierung der beiden Materialien bestehen, und dass das Pulver mit einem pulvermetallurgischen Fertigungsverfahren auf einen Träger zur Bildung des Sputtertargets aufgebracht wird.

14. Verfahren nach Anspruch 13, **dadurch gekennzeichnet, dass** die Schmelze aus 0,1 bis 30 Gew.-% Aluminium und Rest Silizium hergestellt wird.

15. Verfahren nach Anspruch 14, **dadurch gekennzeichnet, dass** die Schmelze aus 5 bis 15 Gew.-% Aluminium und Rest Silizium hergestellt wird.

16. Verfahren nach einem der Ansprüche 13 bis 15, **dadurch gekennzeichnet, dass** das aus den zweiphasigen Körnern bestehende Legierungspulver mittels eines thermischen Spritzverfahrens auf den Träger aufgebracht wird.

17. Verfahren nach einem der Ansprüche 12 bis 16, **dadurch gekennzeichnet, dass** die Körner des verwendeten Pulvers eine sphäroidische Form aufweisen.

18. Verfahren nach einem der Ansprüche 12 bis 17, **dadurch gekennzeichnet, dass** zur Herstellung des Pulvers ein Gasverdüsungsverfahren mit einer luftoffenen Schmelze zum Einsatz kommt.
